(19) Europäisches Patentamt
European Patent Office
Office européen des brevets

(11) **EP 4 503 479 A1**

(12) **DEMANDE DE BREVET EUROPEEN**

(43) Date de publication:
**05.02.2025 Bulletin 2025/06**

(21) Numéro de dépôt: **24192507.2**

(22) Date de dépôt: **02.08.2024**

(51) Classification Internationale des Brevets (IPC):
**H04B 17/12** (2015.01)     **G01R 29/10** (2006.01)
**H01Q 3/26** (2006.01)       **H04B 17/21** (2015.01)
**H04B 17/26** (2015.01)      **G01S 7/40** (2006.01)
**G01S 13/02** (2006.01)

(52) Classification Coopérative des Brevets (CPC):
**H04B 17/12; H01Q 3/267; H04B 17/221;**
**H04B 17/26;** G01R 29/10; G01S 7/4026;
G01S 2013/0254

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(30) Priorité: **04.08.2023 FR 2308469**

(71) Demandeur: **THALES**
**92190 Meudon (FR)**

(72) Inventeurs:
• **Antolin, Mathieu**
  **78851 ELANCOURT CEDEX (FR)**
• **Renard, Christian**
  **78851 ELANCOURT CEDEX (FR)**
• **Leclerc, Frederic**
  **78851 ELANCOURT CEDEX (FR)**
• **Le Bihan, Paul**
  **78851 ELANCOURT CEDEX (FR)**

(74) Mandataire: **Lavoix**
**2, place d'Estienne d'Orves**
**75441 Paris Cedex 09 (FR)**

(54) **PROCÉDÉ AMÉLIORÉ DE CALIBRATION EN CHAMP LOINTAIN D'UNE ANTENNE RÉSEAU ET ANTENNE RÉSEAU CALIBRÉE**

(57)     Le procédé de calibration comporte les étapes consistant à :
- simuler (210) un diagramme de rayonnement environné pour chaque voie de l'antenne réseau ; puis, une plage angulaire de dépointage de l'antenne réseau étant subdivisée en un ou plusieurs intervalles, pour chaque intervalle,
- équilibrer (240) les diagrammes de rayonnement environnés de chaque voie de manière à déterminer un facteur de correction de sorte qu'une dispersion sur les diagrammes de rayonnement environnés soit minimisée;
- mesurer (110) pour chaque voie une erreur globale affectant une loi d'éclairement en transmission et/ou en réception ;
- corriger (120) l'erreur globale mesurée avec le facteur de correction de la voie considérée, de manière à obtenir une erreur corrigée ; et,
- mémoriser (130) l'erreur corrigée pour chaque voie dans la table de calibration du calculateur de pointage de l'antenne réseau.

EP 4 503 479 A1

FIG.2

**Description**

L'invention a pour domaine technique celui des antennes réseaux actives à balayage électronique du faisceau - AESA (« Active Electronically Scanned Array » en anglais), et plus particulièrement celui des procédés de calibration de telles antennes AESA.

Pour qu'une antenne AESA satisfasse les performances radioélectriques souhaitées, il est nécessaire d'identifier et compenser les erreurs sur la loi d'éclairement complexe (c'est-à-dire en amplitude et phase) du réseau rayonnant.

Ces erreurs peuvent être classées en différentes catégories :

- une erreur sur le « signal conduit » résultant d'une dispersion de fabrication des différentes voies (dispersions dans la réalisation mécanique, dispersions dans les caractéristiques électriques des composants utilisés, effets de couplages électromagnétiques dits internes entre les composants, mise en cascade de composants créant une combinaison de désadaptation, etc.)
- une erreur sur le « signal rayonné » résultant d'effets de couplages électromagnétiques dits externes entre les voies.
- une erreur en « température » résultant d'une modification du comportement des composants et des voies avec la température.
- une erreur en « fréquence » résultant d'une modification du comportement des éléments et des voies avec la fréquence ; et,
- une erreur de « vieillissement » résultant d'une évolution des caractéristiques des composants avec le temps.

En ce qui concerne plus particulièrement l'erreur sur le « signal rayonné », la conception d'une antenne AESA passe par une phase initiale où l'on considère le réseau rayonnant comme infini, c'est-à-dire comportant une infinité d'éléments rayonnants. Ceci permet d'optimiser l'adaptation des éléments rayonnants sur une bande de fréquence et un domaine angulaire donné. Le diagramme de rayonnement élémentaire de chaque voie est par conséquent identique d'une voie à l'autre de l'antenne.

Cependant, l'antenne AESA effectivement fabriquée est un réseau rayonnant fini, c'est-à-dire comportant un nombre fini d'éléments rayonnants.

Par effet de couplage électromagnétique, chaque voie du réseau rayonnant fini présente alors un diagramme de rayonnement spécifique, qui dépend de son environnement, en présence de toutes les autres voies de l'antenne. Ce phénomène est connu sous le nom de diagrammes « actifs » ou diagrammes « environnés ».

On observe en particulier des effets de bord (c'est-à-dire lorsque l'élément rayonnant considéré est situé à proximité du bord du réseau) qui causent des déformations du diagramme de rayonnement élémentaire d'une voie, à la fois en amplitude et en phase, par rapport au comportement idéal en réseau rayonnant infini.

Dans un réseau rayonnant fini, chaque diagramme élémentaire subit des déformations différentes, éventuellement aux symétries près.

Le phénomène de diagrammes « environnés » est d'autant plus critique que l'antenne réseau est petite (comptée en longueur d'onde). Ce phénomène est également présent entre diagrammes de rayonnement de sous-réseaux quand plusieurs éléments rayonnants sont associés à un module actif.

Ces déformations des diagrammes de rayonnement élémentaires dégradent la loi d'éclairement du réseau, notamment en phase dans la précision de pointage de l'antenne et en amplitude dans le niveau relativement élevé des « diffus » (c'est-à-dire du gain de l'antenne au-delà des lobes principaux et secondaires).

La « calibration » (ou plus exactement le « calibrage ») d'une antenne AESA consiste à mesurer les erreurs de chemin électrique complexe (c'est-à-dire en amplitude et phase) entre chaque voie de l'antenne AESA.

Dans la suite du présent document, on présentera en détail le cas de la calibration en réception (la sonde de calibration émet et l'antenne reçoit l'onde émise par la sonde), mais le cas de la calibration en émission est tout à fait similaire (l'antenne émet et la sonde de calibration reçoit l'onde émise par l'antenne).

Les commandes appliquées aux composants pilotables de chaque voie afin de modifier, aussi bien en émission qu'en réception, l'amplitude et la phase du signal, émis ou reçu, par les éléments rayonnants associés, doivent tenir compte de ces écarts, notamment afin de compenser la dispersion en amplitude pour éviter des remontées de diffus trop importantes et/ou de compenser la dispersion en phase pour éviter une déviation d'axe native trop importante

Selon l'état de la technique, le procédé de calibration d'une antenne AESA consiste à :

- placer l'antenne dans une position mécanique de référence avec des commandes d'amplitude et de phase de référence sur chaque voie active ; puis,
- effectuer des mesures au moyen d'une sonde disposée le long de l'axe normal à la surface rayonnante de l'antenne et passant par le centre de celle-ci, afin de déterminer, pour chaque voie, des biais en amplitude et en phase, respectivement Cal_RX_A_i et Cal_RX P i, c'est-à-dire les écarts d'amplitude et de phase sur chaque voie par rapport à l'attendu théorique ; et finalement,

- mémoriser les erreurs mesurées pour la fréquence considérée dans une table de calibration.

Ces erreurs sont ensuite compensées par le calculateur de pointage lors de l'utilisation de l'antenne ASEA à la fréquence de travail, en appliquant un déphasage et un gain adéquats entre voies du réseau, en émission ou en réception, afin de dépointer le faisceau rayonné dans la direction souhaitée, avec la forme du faisceau et la topologie des lobes secondaires recherchées.

Le calculateur de pointage calcule un objectif de réglage permettant de compenser ces erreurs.

Ainsi, la mesure lors de la calibration de la fonction de transfert de chaque voie i, Cal_RX_A_i et Cal_RX P i, permet d'alimenter le calculateur de pointage, qui en déduit des objectifs de réglages pour chaque voie en amplitude et en phase, Obj_RX_A_i et Obj_RX_P_i :

$$\text{Obj\_RX\_A\_i} = \text{E\_RX\_A\_i} - \text{Cal\_RX\_A\_i} + \text{Corr\_T\_RX\_A\_i} * (\text{T-T20})$$

$$\text{Obj\_RX\_P\_i} = \text{E\_RX\_P\_i} - \text{Cal\_RX\_P\_i} + \text{Corr\_T\_RX\_P\_i} * (\text{T-T20}) + \text{Phi\_i}$$

où :

- E_RX_A_i et E_RX_P_i correspond à la loi d'illumination en réception en amplitude et en phase (entendue comme l'objectif théorique de réglage permettant d'obtenir un diagramme de rayonnement présentant les caractéristiques désirées) ;
- Corr_T_RX_A_i et Corr_T_P_i correspond à une correction en température à apporter pour la température T courante, liée à la déviation de la valeur connue à la température T20 ; et,
- Phi_i est le déphasage à introduire afin de pointer le faisceau de l'antenne dans une direction voulue.

Les valeurs de ces différents termes peuvent dépendre de la fréquence de fonctionnement et/ou du vieillissement.

De manière connue en soi, la calibration d'une antenne AESA peut s'effectuer suivant soit « en champ proche », soit en « champ lointain » :

Dans l'approche « champ proche », la sonde, qui est à proximité de l'antenne, est déplacée devant chaque voie de l'antenne, afin d'effectuer les mesures permettant de caractériser chaque voie. C'est la méthode généralement retenue pour les antennes de grande dimension et à grand nombre de voies, comme par exemple une antenne radar de pointe avant d'avion de combat.

Dans l'approche « champ lointain », la sonde est positionnée loin de l'antenne. Cette approche C'est la méthode généralement utilisé pour des antennes de petite dimension, exprimée en nombre de longueur d'onde.

L'approche « champ lointain » peut être réalisée soit en extérieur, soit à l'intérieur d'une chambre anéchoïde (en respectant le distance de champ lointain définie par le critère de Fraunhofer), soit encore dans une chambre aux dimensions réduites (ou chambre compacte) en mettant en oeuvre un réflecteur parabolique permettant de simuler un environnement électromagnétique correspondant à une zone très lointaine.

Dans l'approche « champ proche », la sonde étant proche de l'élément rayonnant actif, le diagramme de rayonnement de l'antenne n'est pas formé et l'on considère que l'on mesure uniquement le signal conduit. Cette mesure n'est donc pas affectée par l'erreur sur le signal rayonné, causé par les effets de couplages électromagnétiques entre voies.

Pour des antennes AESA dont le comportement est proche de celui d'un réseau infini, c'est-à-dire d'antennes AESA à très grand nombre de voies actives (plusieurs centaines) et loi d'éclairement pondérée en amplitude pour obtenir des lobes secondaires de faible niveau, on peut considérer que les voies se comportent de manière identique (c'est-à-dire comme une source « centrale »). En conséquence, l'impact de la différence de comportement des voies situées en périphérie du réseau est considéré comme faible. Cette hypothèse est justifiée d'une part parce que ces voies périphériques sont en faible nombre relativement à l'ensemble des voies de l'antenne, et d'autre part parce qu'elles sont fortement pondérées en amplitude.

Dans l'approche « champ lointain », la sonde est loin de l'antenne AESA à caractériser, c'est à dire dans un domaine où le diagramme de rayonnement de l'antenne est formé. La mesure réalisée par la sonde est donc affectée par les effets de couplage entre voies. Ainsi, dans l'approche « champ lointain », la mesure est affectée par l'erreur de signal conduit et par l'erreur de signal rayonné pour chaque voie, mais sans pouvoir faire une distinction entre ces deux contributions.

Si une erreur de signal conduit est sensiblement constante sur l'ensemble des directions de pointage de l'antenne AESA, une erreur de signal rayonné varie en fonction de la direction de pointage.

Le procédé de calibration de l'état de la technique conduit donc à un réglage non optimal de l'antenne AESA, se traduisant par un niveau élevé du rayonnement diffus et/ou une erreur sur la direction de pointage.

Le problème à résoudre est par conséquent de proposer un procédé de calibration en champ lointain permettant de faire la part entre l'erreur de signal conduit et celle de signal rayonné afin de les prendre en compte de manière adaptée, notamment en compensant leurs effets en fonction de la direction de pointage.

Il est à noter que dans la calibration en « champ lointain » en « caisson », la sonde se situant dans une zone intermédiaire, on se base sur une simulation électromagnétique fine pour extraire l'erreur de signal conduit et l'erreur de signal rayonné. On extrapole ensuite les résultats pour déterminer le comportement en rayonnement champ lointain avec de nouvelles simulations électromagnétiques complexes. Certaines simplifications sont cependant possibles pour des antennes réseau à grand nombre de voies.

Le but de cette invention est de résoudre ce problème.

Pour cela l'invention a pour objet un procédé de calibration en champ lointain d'une antenne réseau du type antenne réseau active à balayage électronique du faisceau, l'antenne réseau comportant une pluralité de voies, une voie associant un module d'émission-réception et au moins un élément rayonnant, l'antenne comportant également un calculateur de pointage adapté pour commander individuellement chaque module d'émission-réception, le procédé de calibration comportant les étapes consistant à :

- simuler, au moyen d'une simulation électromagnétique de l'antenne, un diagramme de rayonnement environné pour chaque voie de l'antenne réseau ;
  puis, une plage angulaire de dépointage de l'antenne réseau étant subdivisée en un ou plusieurs intervalles, pour chaque intervalle,
- équilibrer, sur l'intervalle considéré, les diagrammes de rayonnement environnés de chaque voie de l'antenne réseau de manière à déterminer un facteur de correction pour chaque voie de sorte qu'une dispersion sur les diagrammes de rayonnement environnés soit minimisée sur l'intervalle considéré ;
- mesurer, sur l'intervalle considéré, pour chaque voie de l'antenne réseau, une erreur globale affectant une loi d'éclairement en transmission et/ou en réception de la voie considérée ;
- corriger l'erreur globale mesurée avec le facteur de correction de la voie considérée, de manière à obtenir, sur l'intervalle considéré une erreur corrigée pour chaque voie de l'antenne réseau ; et,
- mémoriser, pour l'intervalle considéré, l'erreur corrigée pour chaque voie de l'antenne réseau dans la table de calibration du calculateur de pointage de l'antenne réseau.

Suivant des modes particuliers de réalisation, le procédé de calibration comporte une ou plusieurs des caractéristiques suivantes, prises isolément ou suivant toutes les combinaisons techniquement possibles :

- l'étape consistant à équilibrer les diagrammes de rayonnement environnés consiste à transformer chaque diagramme de rayonnement environné afin de minimiser une section d'une enveloppe contenant l'ensemble des diagrammes de rayonnement environnés transformés ;
- la transformation est l'application d'un gain sur le diagramme de rayonnement environné considéré, le facteur de correction correspondant à la valeur du gain pour la dispersion minimale ;
- une voie comportant un unique élément rayonnant, chaque diagramme de rayonnement environné est un diagramme de rayonnement élémentaire environné ;
- une voie comportant une pluralité d'éléments rayonnants de manière à définir un sous-réseau dans l'antenne réseau, chaque diagramme de rayonnement environné est un diagramme de rayonnement de sous-réseau environné.

L'invention a également pour objet une antenne réseau du type antenne réseau active à balayage électronique du faisceau, calibrée en mettant en oeuvre un procédé de calibration tel que défini ci-dessus.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :

- La figure 1 est une représentation schématique d'une antenne AESA ;
- La figure 2 est une représentation sous forme de blocs du procédé de calibration de l'antenne de la figure 1 ; et,

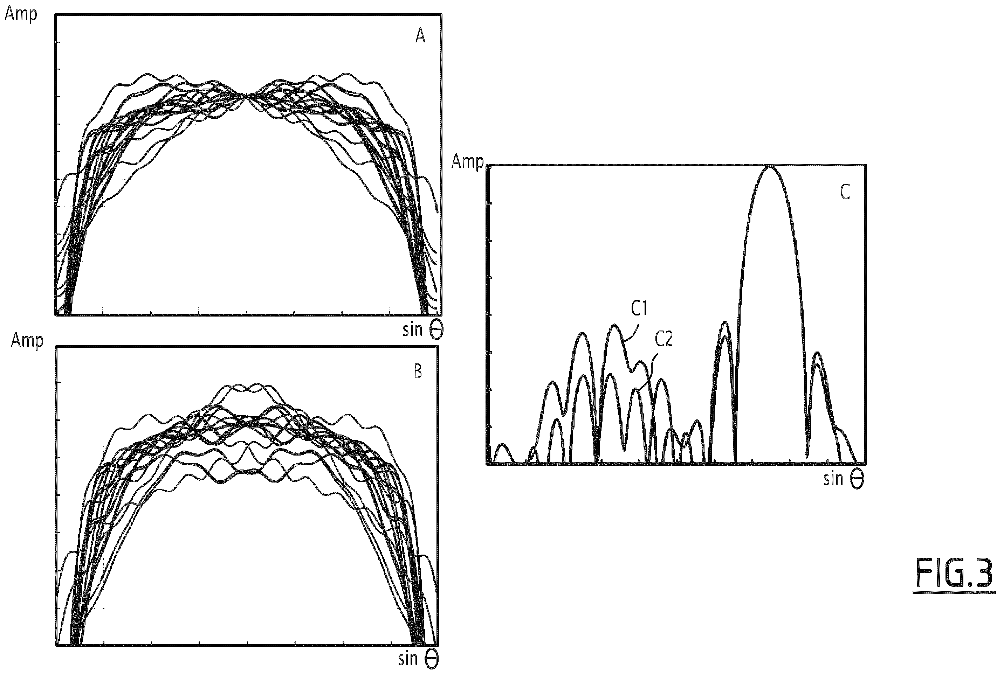

- La figure 3 représente trois graphes respectivement de la superposition des diagrammes de rayonnement élémentaires des voies de l'antenne en réception avec la mise en oeuvre d'un procédé de calibration selon l'état de la technique, de la superposition des diagrammes de rayonnement élémentaires des voies de l'antenne en réception avec la mise en oeuvre du procédé de calibration selon l'invention, et l'amplitude du diagramme de rayonnement de l'antenne d'une part en mettant en oeuvre un procédé de calibration selon l'état de la technique et d'autre part en mettant en oeuvre le procédé de calibration selon l'invention.

La présente invention est relative à un procédé de calibration d'une antenne AESA.

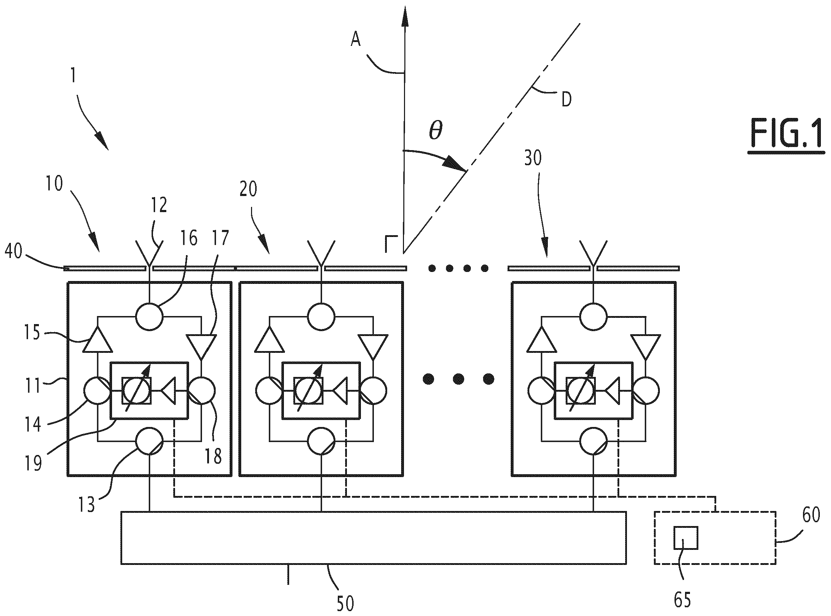

La figure 1 représente de manière schématique une antenne AESA 1.

Elle comporte une pluralité de N voies. Par exemple, sur la figure 1, trois voies sont représentées. Elles sont référencées 10, 20 et 30 sur la figure 1.

Les différentes voies sont similaires entre elles.

En prenant l'exemple de la voie 10, une voie comporte un module de transmission-réception, ou module TR, 11 associé à un élément rayonnant 12. Ce dernier fait saillie au-delà de la face avant de l'antenne 1, qui est constituée par un plan métallique 40.

Le module TR 11 comporte par exemple :

- un commutateur 13 de sélection de la chaîne d'émission ou de la chaîne de réception ;
- un circulateur 16 connecté d'une part aux chaînes d'émission et de réception et d'autre part à l'élément rayonnant ;
- le long de la chaîne d'émission, du commutateur 13 vers le circulateur 16, un déphaseur 14 suivi d'un amplificateur 15 ;
- le long de la chaîne de réception, du circulateur 16 vers le commutateur 13, un l'amplificateur 17 suivi d'un déphaseur 18 ;
- enfin, un dispositif commandable 19 pour modifier la phase et/ou le gain qui sont introduits le long de la chaîne d'émission, respectivement de la chaîne de réception, par le déphaseur 14, respectivement le déphaseur 18.

Un circuit distributeur 50 assure, en émission, la répartition du signal vers chacun des modules TR et, en réception, la sommation des signaux provenant des modules TR.

L'antenne comporte également un calculateur de pointage 60. Ce dernier mémorise une table de calibration 65. Lors de l'utilisation de l'antenne AESA, le calculateur de pointage est propre à calculer un objectif par voie et à commander le dispositif 19 de cette voie pour introduire, en réception et/ou en émission, un déphasage et/ou un gain adapté.

L'axe A est orthogonal au plan 40. Par un ajustement de la phase et du gain des différentes voies, aussi bien en émission qu'en réception, le faisceau de l'antenne peut pointer dans une direction de pointage D faisant un angle de dépointage $\theta$ par rapport à l'axe A.

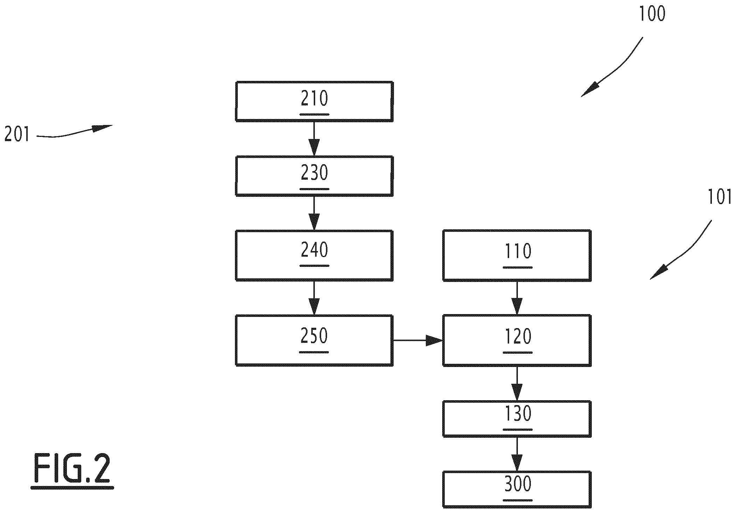

En se référant à la figure 2, va maintenant être présenté un mode de réalisation préféré du procédé de calibration en « champ lointain » pour le réglage de l'antenne AESA 1.

Le procédé 100 comporte une phase de calibration 101 et une phase de détermination de correction 201.

La phase 201 débute par une étape 210 de simulation électromagnétique.

Cette étape prévoit la mise en oeuvre d'un logiciel de simulation électromagnétique. Ce logiciel est utilisé pour simuler le diagramme de rayonnement élémentaire de chaque voie de l'antenne AESA 1.

Pour cette simulation, l'antenne AESA est considérée dans sa géométrie réelle, c'est-à-dire finie.

Pour chaque voie de l'antenne, on simule le diagramme de rayonnement élémentaire théorique de cette voie (seule voie active) en réception, en chargeant toutes les autres voies de l'antenne (voies non-actives) avec une impédance caractéristique.

Cette impédance caractéristique est de préférence celle du circulateur 16 du module TR 11 des voies de l'antenne AESA.

En variante, l'impédance caractéristique est une valeur prédéfinie, par exemple de 50 Ohms.

L'étape 210 permet d'obtenir une pluralité de N diagrammes de rayonnement élémentaires simulés.

La simulation électromagnétique s'intéresse uniquement à l'onde reçue par l'élément rayonnant de la voie active en tenant compte de son environnement électromagnétique.

Elle simule par conséquent la contribution rayonnée.

En revanche, elle ne s'intéresse pas à la contribution conduite.

Les diagrammes de rayonnement élémentaires simulés présentent donc une dispersion qui est uniquement due à une contribution rayonnée.

L'étape 210 permet donc d'obtenir une contribution rayonnée simulée.

Une fois les différents diagrammes de rayonnement élémentaires théoriques obtenus, par simulation, le procédé 100 comporte avantageusement une étape 230.

Pour l'étape 230, la plage angulaire de dépointage du faisceau de l'antenne 1 est subdivisée en une pluralité d'intervalles, de préférence en conservant une symétrie par rapport à $\theta=0$.

Par exemple, la plage $-\theta_{max}+\theta_{max}$ est découpée en trois intervalles $-\theta_{max}-\theta_{max}/3$, $-\theta_{max}/3 +\theta_{max}/3$, et $+\theta_{max}/3 +\theta_{max}$.

L'étape 230 consiste alors à sélectionner un intervalle.

Pour l'intervalle sélectionné, dans l'étape 240, un équilibrage en amplitude des diagrammes de rayonnement élémentaires théoriques est réalisé.

On effectue un équilibrage du niveau relatif des diagrammes de façon à réduire la dispersion entre voies.

Par exemple, cet équilibrage est réalisé en appliquant une transformation sur chaque diagramme de rayonne-

**EP 4 503 479 A1**

ment élémentaire afin de minimiser la section d'une enveloppe contenant, sur l'intervalle considéré, l'ensemble des diagrammes de rayonnement élémentaires environnés ainsi transformés.

De manière connue, l'enveloppe E est par exemple définie par une courbe supérieure $E_{sup}$ et une courbe inférieure $E_{min}$ :

$$E_{sup}(\theta) = \max_{i} RX\_A\_i\_\theta$$

$$E_{min}(\theta) = \min_{i} RX\_A\_i\_\theta$$

La section de cette enveloppe pour le point correspondant à l'angle $\theta$ est la différence entre les courbes supérieure et inférieure en ce point.

On cherche alors à minimiser cette section en appliquant des transformations aux différentes courbes $RX\_A\_i\_\theta$.

La transformation d'un diagramme est par exemple l'application d'un gain sur ce diagramme.

Cette optimisation peut être faite en un point de l'intervalle (par exemple le point médian), en une pluralité de points de l'intervalle, ou sur toute la longueur de cet intervalle.

Chaque diagramme est ainsi corrigé d'un facteur de correction en amplitude. Ce facteur est noté Corr_R-X_A_i_$\theta$.

Enfin, dans l'étape 250, les facteurs de correction en amplitude déterminés à l'étape 240 pour chaque voie i de l'antenne sur l'intervalle en $\theta$ sélectionné sont mémorisés.

Les étapes 230, 240 et 250 sont itérées sur l'intervalle suivant de la plage de dépointage.

Par symétrie, on peut utiliser un facteur de correction semblable sur deux intervalles symétriques l'un de l'autre par rapport à l'angle nul, correspondant à une direction de dépointage selon l'axe A.

La phase 201 s'achève lorsque des facteurs de correction ont été déterminés sur chaque intervalle de subdivision de la plage angulaire.

La phase de calibration 101 débute par une étape 110 de mesure en champ lointain du coefficient de calibration en réception Cal_RX_A_i_$\theta$ de chacune des voies de l'antenne.

Cette mesure inclut par conséquent à la fois la contribution conduite et contribution rayonnée.

De préférence, on considère successivement chaque intervalle de subdivision de la plage de dépointage.

La sonde est placée à un angle $\theta$ par rapport à l'axe A de l'antenne, l'angle $\theta$ appartenant à l'intervalle considéré.

Une voie de l'antenne est activée, alors que les autres voies restent inactives.

Une mesure est effectuée en activant la sonde en émission et en mesurant le signal reçu par la voie activée.

Cette mesure est notée Cal_RX_A_i_$\theta$ où i est un entier d'indexation des voies (i entre 1 et N).

Cette mesure est itérée en activant successivement les différentes voies de manière à obtenir au moins une mesure pour chacune des voies de l'antenne pour l'intervalle considéré.

Dans une étape 120, le coefficient de calibration en émission Cal_RX_A_i_ $\theta$ de la voie i est corrigé avec le résultat de l'étape 240 d'équilibrage pour le même intervalle de dépointage.

Par exemple pour les différents intervalles de la plage de dépointage de l'antenne et pour les différentes voies on calcule :

$$CalCor\_RX\_A\_i\_\theta = Cal\_RX\_A\_i\_\theta - Corr\_RX\_A\_i\_\theta$$

Dans une étape 130, les coefficients de calibration corrigés CalCor_RX_A_i_$\theta$ sont mémorisés dans la table de calibration 65.

Enfin, à la suite du procédé de calibration 100, dans une phase 300 d'utilisation de l'antenne A, lorsque l'on souhaite dépointer la direction d'émission de l'antenne d'un angle $\theta$, pour chaque voix i de l'antenne, une consigne en amplitude est calculée Obj_Amp_i_$\theta$ à partir des coefficients de calibration corrigés CalCorr_RX_Amp_i_$\theta$ présents dans la table de calibration. Cette consigne est appliquée à l'élément ajustable 19 du modules TR 11 de la voie i de l'antenne AESA.

$$Obj\_RX\_A\_i\_\theta = E\_RX\_A\_i\_\theta - CalCorr\_RX\_A\_i\_\theta + Corr\_T\_RX\_A\_i * (T\text{-}T20)$$

Par la mise en oeuvre d'un procédé de calibration similaire à celui venant d'être décrit, un objectif d'amplitude en émission est déterminé pour l'utilisation de l'antenne.

La figure 3A représente la superposition des diagrammes de rayonnement élémentaires d'une antenne AESA (ou plus exactement d'un échantillonnage des diagrammes de rayonnement élémentaires compte tenu de l'existence de symétries haut/bas et gauche/droite à la surface de l'antenne considérée) après la mise en oeuvre d'un procédé de calibration selon l'état de la technique.

La dispersion entre les niveaux des diagrammes de rayonnement élémentaires peut atteindre une amplitude élevée hors de la direction normale, alors qu'elle a été fortement réduite, par exemple annulée (toutes les courbes se croisant en un même point), par calibration dans une unique direction, par exemple la direction normale.

Il subsiste par conséquent une dégradation importante de la loi d'éclairement particulièrement aux dépointages élevés, dégradation induite par le déséquilibre important des différents diagrammes des voies actives.

Comme représenté sur la courbe C1 de la Figure 3C, pour un dépointage angulaire donné non nul, cela conduit à un niveau de diffus élevé (les lobes du diagramme de rayonnement loin de l'axe de pointage du faisceau sont importants). Un tel niveau de diffus est préjudiciable au bon fonctionnement de l'antenne.

La figure 3B représente la superposition des diagrammes de rayonnement élémentaires d'une antenne AESA (ou plus exactement d'un échantillonnage des diagrammes de rayonnement élémentaires compte tenu de l'existence de symétries haut/bas et gauche/droite à la surface de l'antenne considérée) après la mise en oeuvre du procédé de calibration selon l'invention.

On constate que la dispersion entre les niveaux des diagrammes de rayonnement élémentaires est équilibrée sur l'ensemble de la plage de dépointage.

Comme représenté sur la courbe C2 de la Figure 3C, l'amélioration du diffus est substantielle, mieux que 5 dB sur le niveau maximum du diffus.

Le niveau des lobes secondaires est également réduit, même si ce n'est pas aussi significatif.

On s'est attaché précédemment à prendre en compte la dispersion en amplitude des diagrammes de rayonnement élémentaires avec pour objectif de réduire le niveau du rayonnement diffus.

En variante ou en combinaison, on peut appliquer un procédé de calibration similaire pour la phase, en vue de restreindre l'erreur sur la direction de pointage.

La simulation et/ou la mesure de la fonction de transfert de chaque voie en fonction de la direction de pointage permet d'alimenter l'algorithme de pointage, qui en déduit des objectifs de réglages $Obj\_RX\_P\_i\_\theta$ :

$$Obj\_RX\_P\_i\_\theta = E\_RX\_P\_i\_\theta - CalCorr\_RX\_P\_i\_\theta + Corr\_T\_RX\_P\_i * (T\text{-}T20) + Phi\_i$$

Là encore, au lieu d'un objectif en réception, un objectif en émission peut, à la suite d'une procédure de calibration similaire, être calculé au cours de l'utilisation de l'antenne.

Corriger la phase, en particulier sur les bords du domaine de dépointage, permet de réduire à moins de 3 mrad l'erreur de pointage.

La correction systématique ne présente cependant un intérêt que si l'erreur que l'on cherche à compenser est significativement supérieure à l'erreur de quantification des déphaseurs des modules TR des voies.

Contrairement à une calibration en champ proche, la calibration en champ lointain inclut de facto les erreurs de signal rayonné, donc les effets de dispersion des diagrammes élémentaires, et les erreurs de signal conduit, donc les effets de dispersion de fabrication entre les différentes voies.

Avec le procédé de calibration selon l'invention, on simule l'erreur de signal rayonné, ce qui permet ensuite de corriger l'erreur globale mesurée. C'est cette erreur globale corrigée qui est ensuite utilisée pour la définition des objectifs lors de l'utilisation de l'antenne.

En variante, un module TR peut être associé à plus d'un élément rayonnant, délimitant ainsi un sous-réseau dans l'antenne AESA. Chaque secteur est équipé d'un circuit distributeur additionnel entre le module TR et les différents éléments rayonnants. Dit autrement, une voie comporte une pluralité d'élément rayonnants. Dans ce cas, c'est le diagramme de la pluralité des éléments rayonnants associés à une voie, ou diagramme de sous-réseau, que l'on mesure lors de la calibration champ lointain et que l'on ajuste lors de la calibration et non plus le diagramme élémentaire de chaque éléments rayonnant, puisqu'en activant une voie, tous les éléments rayonnants du sous-réseau fonctionnent et les diagrammes élémentaires ne sont pas accessibles individuellement à la mesure. Le procédé selon l'invention s'applique alors mais au niveau d'un sous-réseau. Eventuellement, l'étape de simulation peut porter sur la simulation simultané de l'ensemble des éléments rayonnants de la voie active pour déterminer le diagramme du sous-réseau, ou bien sur la simulation de chaque élément rayonnant de la voie active, avant de combiner ces diagrammes élémentaires simulés pour obtenir le diagramme du sous-réseau.

Les différents sous-réseaux d'une même antenne AESA peuvent avoir une géométrie et regrouper un nombre de voies qui ne sont pas nécessairement identiques, mais présentent généralement au moins une symétrie haut/bas et gauche/droite en vue de face du plan rayonnant de l'antenne AESA.

Le présent procédé trouve un intérêt tout particulier pour les antennes de dimensions faibles (comptées en longueur d'onde) et à nombre de voies réduit, c'est-à-dire pour des antenne AESA dont le comportement est fortement sensible au phénomène de diagrammes « actifs », dans la mesure où une antenne AESA de taille réduite possède un nombre proportionnellement plus important d'éléments rayonnants périphériques et que ces éléments rayonnants périphériques sont sujets aux effets de bord et à des couplages mutuels différents.

Ceci est encore renforcé dans le cas d'antennes AESA constituées de sous-réseaux regroupant chacun plusieurs éléments rayonnants, avec un composant de réglage unique par sous-réseau.

La présente invention trouve une application dans le domaine des radars (de combat ou de surveillance), dans le domaine des autodirecteurs pour missile, dans le domaine des télécommunications (en configuration réception), ou encore dans le domaine de la guerre électronique.

**Revendications**

1. Procédé (100) de calibration en champ lointain d'une antenne réseau du type antenne réseau active à balayage électronique du faisceau, l'antenne réseau comportant une pluralité de voies, une voie associant un module d'émission-réception et au moins un élément rayonnant, l'antenne comportant également un calculateur de pointage adapté pour commander individuellement chaque module d'émission-réception, le procédé de calibration étant **caractérisé en ce qu'**il comporte les étapes consistant à :

   - simuler (210), en champ lointain, au moyen d'une simulation électromagnétique de l'antenne, un diagramme de rayonnement environné pour chaque voie de l'antenne réseau ; puis, une plage angulaire de dépointage de l'antenne réseau étant subdivisée en un ou plusieurs intervalles, pour chaque intervalle,
   - équilibrer (240), sur l'intervalle considéré, les diagrammes de rayonnement environnés de chaque voie de l'antenne réseau de manière à déterminer un facteur de correction pour chaque voie de sorte qu'une dispersion sur les diagrammes de rayonnement environnés soit minimisée sur l'intervalle considéré, le facteur de correction correspondant à une erreur de signal conduit ;
   - mesurer (110), en champ lointain, sur l'intervalle considéré, pour chaque voie de l'antenne réseau, une erreur globale affectant une loi d'éclairement en transmission et/ou en réception de la voie considérée ;
   - corriger (120) l'erreur globale mesurée avec le facteur de correction de la voie considérée, de manière à obtenir, sur l'intervalle considéré une erreur corrigée pour chaque voie de l'antenne réseau, l'erreur corrigée correspondant à une erreur de signal rayonné ; et,
   - mémoriser (130), pour l'intervalle considéré, l'erreur corrigée pour chaque voie de l'antenne réseau dans la table de calibration du calculateur de pointage de l'antenne réseau.

2. Procédé selon la revendication 1, dans lequel l'étape consistant à équilibrer les diagrammes de rayonnement environnés consiste à transformer chaque diagramme de rayonnement environné afin de minimiser une section d'une enveloppe contenant l'ensemble des diagrammes de rayonnement environnés transformés.

3. Procédé selon la revendication 2, dans lequel la transformation est l'application d'un gain sur le diagramme de rayonnement environné considéré, le facteur de correction correspondant à la valeur du gain pour la dispersion minimale.

4. Procédé selon l'une quelconque des revendications 1 à 3, dans lequel, une voie comportant un unique élément rayonnant, chaque diagramme de rayonnement environné est un diagramme de rayonnement élémentaire environné.

5. Procédé selon l'une quelconque des revendications 1 à 3, dans lequel, une voie comportant une pluralité d'éléments rayonnants de manière à définir un sous-réseau dans l'antenne réseau, chaque diagramme de rayonnement environné est un diagramme de rayonnement de sous-réseau environné.

6. Antenne réseau (1) du type antenne réseau active à balayage électronique du faisceau, **caractérisée en ce qu'**elle est calibrée en mettant en oeuvre un procédé de calibration conforme à l'une quelconque des revendications précédentes.

FIG.1

EP 4 503 479 A1

FIG.2

FIG.3

Europäisches
Patentamt

European
Patent Office

Office européen
des brevets

## RAPPORT DE RECHERCHE EUROPEENNE

Numéro de la demande

EP 24 19 2507

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2020/028598 A1 (JING YA [CN] ET AL) 23 janvier 2020 (2020-01-23) * abrégé * * alinéas [0022] - [0024] * * alinéas [0034] - [0040]; figure 3A * * alinéas [0042] - [0045]; figure 5 * * alinéas [0048] - [0049]; figure 3B * ----- | 1-6 | INV. H04B17/12 G01R29/10 H01Q3/26 H04B17/21 H04B17/26 G01S7/40 |
| X | CN 109 541 558 A (SPACE STAR TECHNOLOGY CO LTD) 29 mars 2019 (2019-03-29) * abrégé * * alinéas [0061] - [0082] * * figures 2-4 * ----- | 1-6 | ADD. G01S13/02 |

**DOMAINES TECHNIQUES RECHERCHES (IPC)**

H04B
H01Q
G01R
G01S

Le présent rapport a été établi pour toutes les revendications

| Lieu de la recherche | Date d'achèvement de la recherche | Examinateur |
|---|---|---|
| La Haye | 5 décembre 2024 | Yang, Betty |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 19 2507

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-12-2024

| Document brevet cité au rapport de recherche | Date de publication | Membre(s) de la famille de brevet(s) | Date de publication |
|---|---|---|---|
| US 2020028598 A1 | 23-01-2020 | CN 110542798 A<br>US 2020028598 A1 | 06-12-2019<br>23-01-2020 |
| CN 109541558 A | 29-03-2019 | AUCUN | |

EPO FORM P0460

Pour tout renseignement concernant cette annexe : voir Journal Officiel de l'Office européen des brevets, No.12/82